# EUROPÄISCHE PATENTANMELDUNG

(11) **EP 1 215 725 A2**
(43) Veröffentlichungstag der Anmeldung: **19.06.2002**
(21) Anmeldenummer: 01129933.6
(22) Anmeldetag: 17.12.2001
(51) Int. Cl.: H01L 23/498, H01L 21/60

(54) **Anordnung zur Aufnahme elektrischer Bauteile und kontaktloser Transponder**

(30) Priorität: 18.12.2000 DE 10062811
(71) Anmelder: cubit electronics Gmbh, 99099 Erfurt (DE)
(72) Erfinder: Michalk, Manfred, Dr., 99096 Erfurt (DE)
(74) Vertreter: Liedtke, Klaus, Dr.

(57) **Zusammenfassung**

1. Anordnung zur Aufnahme elektrischer Bausteine und kontaktloser Transponder

2.1 Der Erfindung liegt die Aufgabe zugrunde, eine Anordnung anzugeben, die als Zwischenträger mit mindestens einem aktiven oder passiven elektrischen Baustein geeignet ist, wobei deren Transport zur Kontaktierstelle in bzw. mit der übergeordneten elektrischen Schaltung und dessen Herauslösung aus dem Transportverband mit einfachen technischen Mitteln möglich ist und wobei der Zwischenträger so gestaltet ist, dass dieser optisch kodierbar und oder als Kondensator zusätzlich nutzbar ist.

2.2 Erfindungsgemäß gelingt die Lösung der Aufgabe dadurch, dass eine Mehrzahl von Zwischenträgern, auf denen sich mindestens eine obere Metallschicht befindet, welche aus einem äußeren Kontaktfeld, einem inneren Kontaktfeld und einer diese verbindende Zuleitung besteht, in einer endlosen Bandform so auf einem Bandträger angeordnet sind, dass die äußeren Kontaktfelder jeweils in Richtung der benachbarten Zwischenträger weisen und der Transponder eine Anordnung zur Aufnahme aktiver oder passiver elektrischer Bausteine nach einem der Ansprüche 1 bis 10 enthält.

2.3 Die Erfindung betrifft eine Anordnung zur Aufnahme aktiver oder passiver elektrischer Bausteine auf einer flexiblen, elektrisch isolierenden, miniaturisierten Trägerfolie und einen kontaktlosen Transponder.

## Beschreibung

Die Erfindung betrifft eine Anordnung zur Aufnahme aktiver oder passiver elektrischer Bausteine auf einer flexiblen, elektrisch isolierenden, miniaturisierten Trägerfolie und einen kontaktlosen Transponder.

Derartige auch als Zwischenträger bezeichnete elektronische Schaltungsträger dienen zur Aufnahme einer oder weniger elektronischer Komponenten. Sie werden benutzt, um künftige integrierte Schaltungen vorab mittels eines Schaltungsaufbaus mit diskreten Bauelementen in der realen übergeordneten elektrischen Schaltung zu testen oder um die Weiterverarbeitung von an sich schwierig oder kostenaufwendig handhabbaren elektronischen Bauelementen zu vereinfachen.
Insbesondere bei der Herstellung von kontaktlosen Chipkarten werden seit 1993 z. B. durch die Fa. Interlock (Schweiz), cubit electronics GmbH (Deutschland), PAV (Deutschland) und OMRON (Japan) Zwischenträger eingesetzt mit dem Bestreben, die Kontaktierung des Halbleiterchips auf einem möglichst einfachen, sehr flachen und flexiblen Schaltungsträgerstück zu vollziehen und diesen Zwischenträger danach mit den Antennenanschlüssen des kontaktlosen Transponders zu verbinden. Als kontaktlose Transponder werden dabei insbesondere kontaktlose Chipkarten, Waren oder Warenverpakkungen mit eingearbeiteten Antennen und Transponderchip, elektronische kontaktlose Etiketten, Tickets, Wertscheine etc. verstanden.
Die Zwischenträger werden zuvor aus einem größeren, sich wiederholenden Schaltungsverband getrennt, gegebenenfalls in Magazinen oder anderen Trägern zwischengelagert, zum Kontaktierort gefördert und danach kontaktiert. Diese Verfahrensweise bedingt einen hohen technischen Aufwand beim Befördern und Kontaktieren und schränkt die Geschwindigkeit des Kontaktiervorganges insgesamt ein.
Bekannt ist auch die Nutzung von Schaltungsträgern mit doppelseitiger Metallisierung und dünnem elektrisch isolierenden Trägermaterial als Abstimmkapazität für Transponderschwingkreise. Eventuelle Fehllagen der Resonanzfrequenz, die sich aus den elektronischen Eigenschaften von Transponderchip (Halbleiterschaltkreis) und geätzter Spule ergeben, sollen durch einen kleinen Kondensator, dessen Kapazität sich aus den beiderseits des Isolators ausgebildeten Metallflächen ergibt und wobei die eine Fläche kammförmig gestaltet ist, korrigiert werden in der Art, dass je nach Frequenzabweichungsgröße Teile der Kammstruktur z. B. durch Laserschnitt abgetrennt werden und damit die Resonanzfrequenz sich insgesamt nach höheren Werten verschiebt.
Diese substraktive Methode der Kapazitätstrimmung verwendet Texes Instruments für kontaktlose Transponder im Frequenzbereich von 13,56 MHz.
Weiterhin ist es bekannt, dass mittels langwelligem Laserlicht (Wellenlängen in 10 µm-Bereich), z. B. CO₂-Laser, vor allem Kunststoffe, Faserstoffe usw. durch explosionsförmigen Abtrag schnell und präzise getrennt oder partiell abgetragen werden können (Firmenprospekt der Fa. Jet-Laser, Deutschland).

Weiterhin ist es im Stand der Technik bekannt, mittels kurzwelligen Laserlichts (Wellenlängenbereich bei ~ 1 µm) Metalle abzutragen, kurzzeitig aufzuschmelzen, zu sintern, zu legieren, zu verformen sowie zu verschweißen und zu verlöten.

Der Erfindung liegt die Aufgabe zugrunde, eine Anordnung anzugeben, die als Zwischenträger mit mindestens einem aktiven oder passiven elektrischen Baustein geeignet ist, wobei deren Transport zur Kontaktierstelle in bzw. mit der übergeordneten elektrischen Schaltung und dessen Herauslösung aus dem Transportverband mit einfachen technischen Mitteln möglich ist und wobei der Zwischenträger so gestaltet ist, dass dieser optisch kodierbar und oder als Kondensator zusätzlich nutzbar ist.

Erfindungsgemäß wird die Aufgabe mit einer Anordnung, welche die in Anspruch 1 angegebenen Merkmale und mit einem kontaktlosen Transponder, welcher die in Anspruch 14 angegebenen Merkmale aufweist, gelöst.

Vorteilhafte Ausgestaltungen sind in den Unteransprüchen angegeben.

Bei der erfindungsgemäßen Anordnung sind die Zwischenträger in Bandform so angeordnet, dass sich ein endloser Zwischenträgerverband ergibt. Der einzelne Zwischenträger ist abfallfrei vom Band abschneidbar. Dabei sind die äußeren Kontaktfelder der Zwischenträger so angeordnet, dass sie jeweils in Richtung benachbarter Zwischenträger zeigen. Der Trägerfolienwerkstoff zwischen den Zwischenträgern ist vollständig oder nahezu vollständig entfernt.
Eine vorteilhafte Ausführung sieht vor, die in Zwischenträgerbandlaufrichtung zeigenden äußeren Kontaktfelder der Zwischenträger in Laufrichtung so zu verlängern, dass sie den Trennspalt überbrücken und die Trägerfolie des vorlaufenden Zwischenträgers überlappen und mit ihr fast verbunden sind.

Die Erfindung zeichnet sich durch eine Reihe von Vorteilen aus. Hierzu zählen insbesondere:
1. Die Zwischenträger können als Band leicht auf- bzw. abgewickelt werden. Es sind deshalb zur Aufbewahrung der Zwischenträger keine Magazine erforderlich.
2. Die zur Separatierung der Zwischenträger erforderlichen abfallfreien Trennvorgänge verlaufen abseits der Kontaktierzonen von empfindlichen Bauteilen wie Halbleiterchips, Kondensatoren, Induktivitäten etc.
3. Die verbleibenden Metallüberlappungen lassen sich einfacher schneiden als sehr dünne Plaste-Trägerfolien; sie können bei Bedarf im Trennspaltbereich mit Perforationslöchern versehen sein.
4. Mit einer laschenförmigen Strukturierung der Überlappung kann ein eventuell erforderliches schneidtechnisches Trennen vereinfacht werden.
5. Die beim Kontaktieren stattfindende temporäre starke Verringerung der Klebeverbundfestigkeit der äußeren Kontaktfelder des gerade zu kontaktierenden Zwischenträgers wird ausgenutzt um die ebenfalls mit erhitzte Überlappung des im Zwischenträgerband folgenden Zwischenträgers allein durch eine sehr kurze Zugbewegung von der Trägerfolie des zu kontaktierenden Zwischenträgers ohne weitere Hilfsmittel zu lösen.
6. Die Zwischenträger werden nur geringen Belastungen ausgesetzt, wobei Verbiegung oder Verdrehung der Zwischenträger verhindert werden.
7. Für die Fertigung ergibt sich eine sehr hohe Produktivität.
8. Bei Ausführungen mit unterer Metallschicht werden per Flipchip-Bondung kontaktierte Chips vor Lichteinfall auf die aktive Chipseite geschützt.
9. Die untere Metallschicht sowie das Trägermaterial des Zwischenträgers kann für Zusatzfunktionen verwendet werden, beispielsweise lassen sich durch Farbdruck, Lasergravur oder andere Verfahren zur Codierung geeignete Kennzeichnungen aufbringen.
10. Außerhalb der äußeren Kontaktfelder kann die gesamte Trägerfolienunterseite mit einer unteren Metallschicht versehen sein, so dass sich entsprechend der gewählten Größe und Dicke der Trägerfolie sowohl ein Abgleich der Antennenresonanzfrequenz realisieren lässt, als auch trotz geringerer Anzahl von Antennenwindungen eine größere Schreib-/Lesereichweite erzielt werden kann.
11. Im Gegensatz zu bisherigen substraktiven Verfahren sind zur Kapazitätstrimmung keine thermisch oder mechanisch schneidende Verfahren erforderlich, da die Trimmung ausschließlich durch verformende Verfahren, wie Druck-Wärme-Eintrag oder Ultraschalleintrag auf den beabsichtigten Bereich der Kammstruktur erfolgt.

Die Erfindung wird im Folgenden anhand eines Ausführungsbeispiels näher erläutert.

In den zugehörigen Zeichnungen zeigen:
- Figur 1: ein Zwischenträgerband mit mehreren Zwischenträgern in der Draufsicht,
- Figur 2: die Draufsicht auf eine Trennstelle zwischen zwei Zwischenträgern,
- Figur 3: die Seitenansicht der Trennstelle zwischen zwei ZwischenTrägern in Schnittdarstellung,
- Figur 4: einen Zwischenträger mit Kondensatoraufbau in der Schnittdarstellung in Seitenansicht
und
- Figur 5: einen Zwischenträger mit Kondensatoraufbau in der Draufsicht.

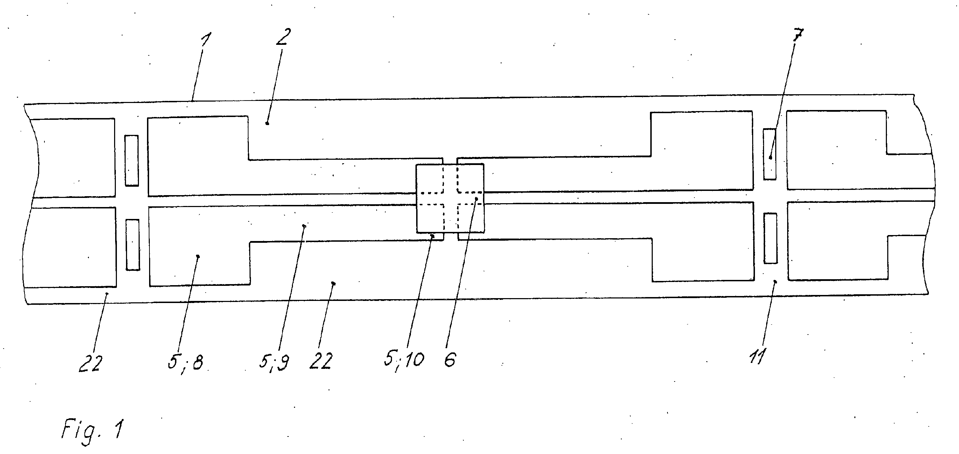

In **Figur 1** sind eine Reihe von Zwischenträgern 1 linear zu einem Zwischenträgerband 22 angeordnet. Jeder Zwischenträger weist entlang einer schmalen Stirnseite je ein äußeres Kontaktfeld 8 auf, welche in der übergeordneten Schaltung mit deren Kontaktfeldern zu verbinden sind. Von den äußeren Kontaktfeldern 8 führen Zuleitungen 9 zu den inneren Kontaktfeldern 10. Auf den inneren Kontaktfeldern 10 ist ein Halbleiterchip 6 mittels Flip-Chip-Kontaktierverfahren befestigt. Die obere Metallschicht 5, aus der äußere Kontaktfelder 8, Zuleitungen 9 und innere Kontaktfelder 10 strukturiert sind, besteht im Beispiel aus einer 18 µm dicken Kupferschicht.

Zwischen oberer Metallschicht 5 und der Oberseite 4 der Trägerfolie 2, die im Beispiel aus einer 25µm dicken Polyesterschicht besteht, befindet sich eine etwa 5 bis 10 µm dicke Kleberschicht 24. Die Trägerfolie 2 weist an den Trennstellen 11 zwischen je zwei Zwischenträgern 1 Perforationslöcher 7 auf. Sie dienen der Verringerung der Schnittkräfte beim mechanischen Abtrennen jeweils eines Zwischenträgers 1 vom an sich "endlosen" Zwischenträgerband 22. Das Zwischenträgerband 22 ist ohne Beachtung eventueller Spurlagen auf einer Spule aufgewickelt, deren Wickelbreite wesentlich größer als die Breite des Zwischenträgerbandes 22 ist. Im Beispiel weist der Zwischenträgers 1 eine Breite von 4 mm und eine von Länge 14 mm auf.

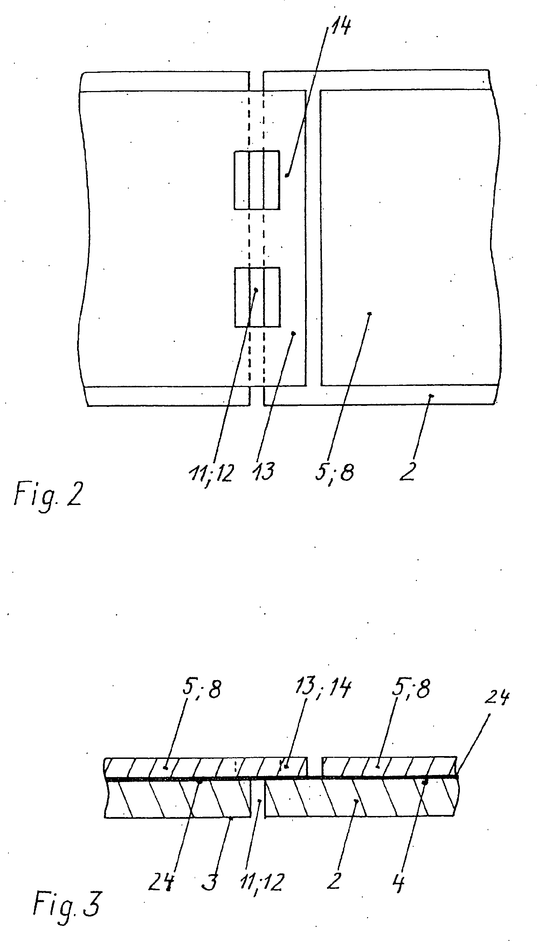

Die Trennstelle 11 weist gemäß **Figur 2** zwischen den einzelnen Trägerfolienabschnitten 2 der Zwischenträger 1 einen ca. 200 µm breiten Trennspalt 12, der frei von Trägerfolienmaterial 2 ist, auf. Dieser Trennspalt 12 ist im Beispiel mittels eines gepulsten CO₂-Lasers erzeugt worden. Den Trennspalt 12 überlappen vier Laschen 14, die Fortsetzungen der Metallschicht 5 des jeweils in Abspul-Richtung des Zwischenträgerbandes 22 zeigenden äußeren Kontaktfeldes 8 darstellen. Die Überlappungen 13 verlaufen auf dem Nachbarzwischenträger 1 über eine Länge von 400 µm und deren Metallschicht 5 ist mittels Kleber 24 fest mit der Oberseite 4 der Trägerfolie 2 verbunden. Zwischen den Laschen 14 und dem äußeren Kontaktfeld 8 des benachbarten Zwischenträgers 1 besteht im Beispiel ein Abstand von 100 µm. Die gesamte obere Metallschicht 5 wurde in einem Arbeitsschritt ätztechnisch strukturiert. Dabei befanden sich mehrere Reihen Zwischenträgerband auf einem insgesamt 100 mm breiten Nutzenband nebeneinander. Im Beispiel wurde das Nutzenband danach mittels CO₂-Laser in 4 mm breite Zwischenträgerbänder 22 getrennt unter nahezu gleichzeitiger Erzeugung des Trennspaltes 12.

**Figur 3** zeigt die Trennstelle 11 zwischen den Zwischenträgern 1 in der Seitenansicht. Die Laschen 13 überqueren den Trennspalt 12 und sind im folgenden Verlauf auf der Oberseite 4 der Trägerfolie 2 des benachbarten Zwischenträgers 2 befestigt. Sie stellen den mechanischen Verbund der Zwischenträger 1 zu einem Zwischenträgerband 22 her.

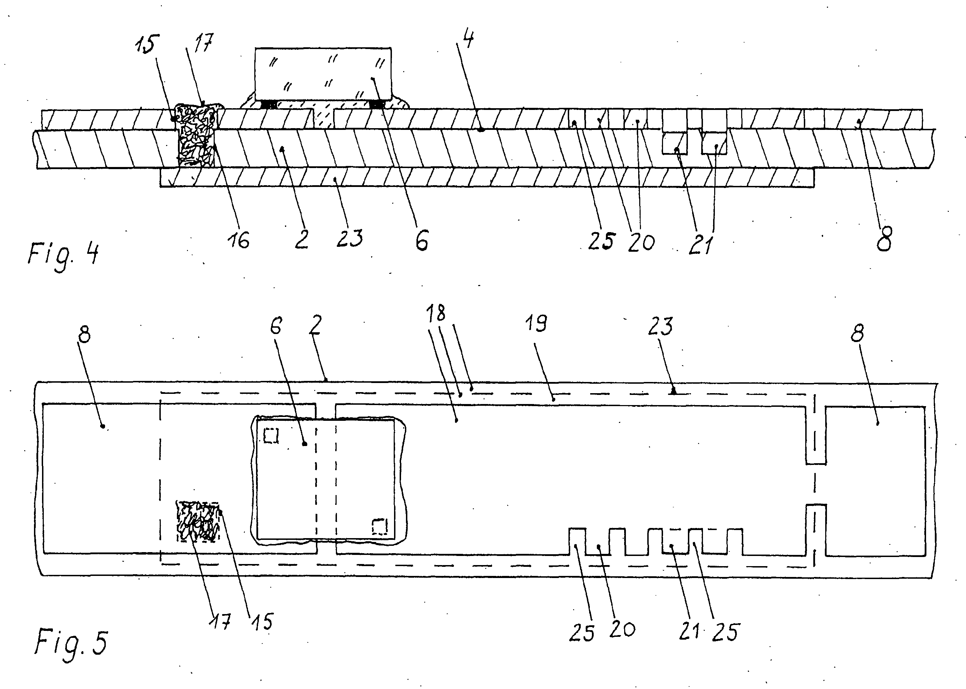

Bei der in den **Figuren 4 und 5** gezeigten Anordnung ist aus Trägerfolie 2, oberer Metallschicht 5 und unterer Metallschicht 23 ein elektrischer Kondensator 18 gebildet worden, der zu dem im Beispiel zweipoligen Halbleiterchip 6 parallel geschaltet ist. Die Zuleitung 9 eines äußeren und inneren Kontaktfeldes 8; 10 weist im Beispiel ein Loch 15 mit 200 µm Durchmesser auf. Die Trägerfolie 2 ist ebenfalls mit einem Loch 16 versehen, welches durch gepulste CO₂-Laserstrahlung erzeugt wurde. Dabei dient das nasschemisch erzeugte Ätzloch 15 der oberen Metallschicht 5 als Belichtungsmaske für den CO₂-Laser-Strahl.
Die genau untereinander liegenden Löcher 15 und 16 sind danach mit einer Lötpaste 17 aus Zinn mit Wismutanteilen gefüllt worden. Die Lötpaste 17 ist mittels kurzwelligen Diodenlaserstrahl der Wellenlänge von ca. 1 µm aufgeschmolzen worden; danach verbindet das wieder erstarrte Lot 17 die untere Metallschicht 23 dauerhaft mit der oberen Metallschicht 5. Ein äußeres Kontaktfeld 8 ist damit mit der unteren Metallschicht 23 fest kontaktiert über die Zuleitung 9. Die Zuleitung 9, die sich zwischen dem anderen, zweiten inneren und dem äußeren Kontaktfeld 10 und 8 befindet, ist (konstruktiv) maximal breit und lang ausgeführt, um eine maximale Kondensatorfläche zu bilden, die der Kondensatorfläche der unteren Metallschicht 23 ebenenparallel, getrennt durch die Trägerfolie 2, gegenübersteht. Damit bildet ein wesentlicher Flächenanteil des Zwischenträgers 1 einen Kondensator 18.
An einem Rand der zur Kondensatorfläche erweiterten Zuleitung 9 befindet sich ein Justierkamm 20, dessen vier Zinken je eine Fläche von 1,5 mm² aufweisen. Die Zinken befinden sich zwischen fünf Kammfreiräumen 25. Die untere Metallschicht 23 überragt allseitig die ebenenparallele obere Metallschicht 5, die Bestandteil des zweiten Anschlusses ist.

In Figur 4 ist dargestellt, wie durch Tiefsetzen zweier Justierkammzinken 21 die Dicke der Trägerfolien 2 zwischen diesen abgesenkten Justierkammzinken 21 und der unteren Metallschicht 23 verringert und damit die Kapazität des Kondensators 18 erhöht wurde. Die äußeren Kontaktfelder 8 sind nicht von der unteren Metallschicht 23 überdeckt.

Eine vorteilhafte Ausführung sieht vor, dass das äußere Kontaktfeld 8, das zum Kontaktfeld 8 des nachfolgenden Zwischenträgers 1 zeigt und seine eventuell zwischen dem äußeren Kontaktfeldmetall und der Trägerfolie 2 liegende Kleberschicht 24 und/oder die angrenzende Oberseite 4 der Trägerfolien 2 und die Überlappung 13 des äußeren Kontaktfeldes 8 des nachfolgenden Zwischenträgers 1 und dessen angrenzenden Kleberschicht 24 und/oder Oberseite 4 der Trägerfolie 2 während des Kontaktiervorganges des Zwischenträgers 1 auf die übergeordnete Schaltung so erhitzt werden, dass die Klebeverbundfestigkeit von Metall zur Kleberschicht 24 bzw. zur Oberseite 4 der Trägerfolie 2 temporär sehr stark verringert wird und gleichzeitig in dieser Kontaktierphase durch Rückziehen des nachfolgenden Zwischenträgers 1 vom im Moment zu kontaktierenden Zwischenträger 1 um mindestens die Überlappung vom Zwischenträgers 1 abgezogen wird und dadurch der zu kontaktierende Zwischenträger 1 vom nachfolgenden Zwischenträger 1 getrennt wird.

Durch Druck- und/oder Wärmebehandlung, die durch Ultraschalleinwirkung unterstützt werden kann, können Elemente des Justierkammes 20 so in die Trägerfolie 2 eingepresst werden, dass sie permanent einen verringerten Abstand zur gegenüberliegenden Metallschicht einnehmen und insgesamt die Kapazität des aus der Trägerfolie 2 und unterer 23 und oberer Metallschicht 5 des Zwischenträgers 1 gebildeten Kondensator 18 um ein vorgegebenes Maß steigt.

### BEZUGSZEICHENLISTE

- 1: Zwischenträger
- 2: Trägerfolie
- 3: Unterseite der Trägerfolie
- 4: Oberseite der Trägerfolie
- 5: obere Metallschicht
- 6: Halbleiterchip
- 7: Perforationsloch
- 8: äußeres Kontaktfeld
- 9: Zuleitung
- 10: inneres Kontaktfeld
- 11: Trennstelle
- 12: Trennspalt
- 13: Überlappung
- 14: Lasche
- 15: Ätzloch in Metallschicht
- 16: Loch in Trägerschicht
- 17: elektrisch leitendes Füllmaterial
- 18: Kondensator
- 19: Überstand
- 20: Justierkamm
- 21: abgesenkter Teil des Justierkammes
- 22: Zwischenträgerband
- 23: untere Metallschicht
- 24: Kleberschicht
- 25: Kammfreiraum

## Patentansprüche

1. Anordnung zur Aufnahme aktiver oder passiver elektrischer Bausteine auf einer flexiblen, elektrisch isolierenden, miniaturisierten Trägerfolie (2), **dadurch gekennzeichnet, dass** eine Mehrzahl von Zwischenträgern (1), auf denen sich mindestens eine obere Metallschicht (5) befindet, welche aus einem äußeren Kontaktfeld (8), einem inneren Kontaktfeld (10) und einer diese verbindende Zuleitung (9) besteht, in einer endlosen Bandform so auf einem Bandträger (22) angeordnet sind, dass die äußeren Kontaktfelder (8) jeweils in Richtung der benachbarten Zwischenträger (1) weisen.

2. Anordnung nach Anspruch 1, **dadurch gekennzeichnet, dass** zwischen benachbarten Zwischenträgern (1) auf dem Zwischenträgerband (22) Perforationen (7) oder Trennspalte (12) angebracht sind.

3. Anordnung nach Anspruch 1 oder 2, **dadurch gekennzeichnet, dass** die in Laufrichtung des Zwischenträgerbands (22) zeigenden Außenbereiche (8) der Kontaktfelder der Zwischenträger (1) in Laufrichtung soweit verlängert sind, dass sie die zwischen den Zwischenträgern (1) bestehenden Trennspalte (12) überbrücken und die Trägerfolie (2) des vorlaufenden Zwischenträgers (1) überlappen und mit dieser fest verbunden sind.

4. Anordnung nach Anspruch 3, **dadurch gekennzeichnet, dass** das überlappende Metall laschenförmig strukturiert ist.

5. Anordnung nach einem der vorhergehenden Ansprüche, **dadurch gekennzeichnet, dass** die Trägerfolie (2) an ihrer Unterseite (3) mindestens im Bereich unterhalb der inneren Kontaktfelder (10) mit einer unteren Metallschicht (23) versehen ist.

6. Anordnung nach Anspruch 5, **dadurch gekennzeichnet, dass** die untere Metallschicht (23) und die auf der Oberseite (4) der elektrisch isolierenden, dielektrischen Trägerfolie (2) angeordnete obere Metallschicht (5) nahezu deckungsgleiche Flächen aufweisen, die einen Kondensator (18) bilden.

7. Anordnung nach Anspruch 5 oder 6, **dadurch gekennzeichnet, dass** die Zuleitung (9) eines Kontaktfeldes mit der unteren Metallschicht (23) elektrisch leitend verbunden ist.

8. Anordnung nach Anspruch 7, **dadurch gekennzeichnet, dass** die Zuleitung (9) eine Lochstruktur (15) aufweist, die direkt unter dem Lochbereich liegende Trägerfolie (2) eine Öffnung (16) aufweist und das Lochvolumen mit elektrisch leitendem Material (17) so gefüllt ist, dass dieses Material Zuleitung (9) und untere Metallschicht (23) elektrisch verbindet.

9. Anordnung nach Anspruch 5 bis 8, **dadurch gekennzeichnet, dass** die obere Metallschicht (5) und/oder dic untere Metallschicht (23) im zur Kondensatorbildung erzeugten Deckungsbereich mindestens in einem Teilrandbereich Kammstrukturen (20, 25) aufweisen.

10. Anordnung nach Anspruch 9, **dadurch gekennzeichnet, dass** zumindest Teile der Kammstrukturen (20, 25) abgesenkt sind.

11. Verwendung der Anordnung nach einem der vorhergehenden Ansprüche, **dadurch gekennzeichnet, dass** die Anordnung mit einer Vielzahl von Zwischenträgern (1) gemeinsam mit elektronischen Bauelementen bestückt wird, indem die inneren Kontaktfelder (10) mit Anschlüssen der elektronischen Bauelemente kontaktiert werden.

12. Verwendung nach Anspruch 11, **dadurch gekennzeichnet, dass** an den Zwischenträgern (1) das äußere, zum Kontaktfeld (8) des nachfolgenden Zwischenträgers (1) zeigende Kontaktfeld (8) und seine eventuell zwischen äußeren Kontaktfeldmetall und Trägerfolie (2) liegende Kleberschicht (24) und/oder die angrenzende Oberseite der Trägerfolien (2) und die Überlappung (13) des äußeren Kontaktfeldes (8) des nachfolgenden Zwischenträgers (1) und/oder die Oberseite (4) der Trägerfolie (2) mit einer Kleberschicht (24) versehen sind.

13. Verwendung nach einem der Ansprüche 11 oder 12, **dadurch gekennzeichnet, dass** die äußeren Kontaktfeld (8) des nach der Überlappung (13) des nachfolgenden Zwischenträgers (1) und deren angrenzende Kleberschichten (24) und/oder Oberseiten (14) der Trägerfolie (2) während des Kontaktiervorganges des Zwischenträgers (1) auf die übergeordnete Schaltung so erhitzt werden, dass die Klebeverbundfestigkeit Metall zu Kleberschicht (24) oder Oberseite (4) der Trägerfolie (2) temporär sehr stark verringert wird und gleichzeitig in dieser Kontaktierphase durch Rückziehen des nachfolgenden Zwischenträgers (1) vom im Moment zu kontaktierenden Zwischenträger (1) um mindestens die Überlappung (13) vom Zwischenträgers (1) abgezogen wird und dadurch der zu kontaktierende Zwischenträger (1) vom nachfolgenden Zwischenträger (1) getrennt wird.

14. Kontaktloser Transponder, vorzugsweise kontaktlose Chipkarte, **dadurch gekennzeichnet, dass** der Transponder eine Anordnung zur Aufnahme aktiver oder passiver elektrischer Bausteine nach einem der Ansprüche 1 bis 10 enthält.
